# EUROPEAN PATENT APPLICATION

(11) **EP 3 518 291 A1**
(43) Date of publication of application: **31.07.2019**
(21) Application number: 18183591.9
(22) Date of filing: 16.07.2018
(51) Int. Cl.: H01L 31/032, H01L 31/0749

(54) **THIN-FILM SOLAR CELL**

(30) Priority: 29.01.2018 CN 201810083952
(71) Applicant: Beijing Apollo Ding Rong Solar Technology Co., Ltd., Beijing 100176 (CN)
(72) Inventor: NIE, Man, Beijing, Beijing 100176 (CN); YANG, Lihong, Beijing, Beijing 100176 (CN)
(74) Representative: Peguet, Wilfried

(57) **Abstract**

A thin-film solar cell is disclosed. The thin-film solar cell comprises a substrate (100) on which a first conductive layer (200), a first alkaline element layer (300), a light absorption layer (400), a second alkaline element layer (500) and a transparent conductive layer (700) are sequentially disposed. According to the thin-film solar cell of the present disclosure, by disposing the second alkaline element layer (500), an alkali metal element in the second alkaline element layer (500) reacts with elements in the light absorption layer (400) to form a film layer containing the alkali metal element, thereby changing the composition of the surface of the light absorption layer (400), and further changing the electronic structure of the light absorption layer (400) by ion exchange, reducing the surface recombination of charge carriers between the layers, so that an open-circuit voltage of the cell is increased in the post-preparation processing, thereby improving the photoelectric conversion efficiency of the cell.

## Description

### CROSS-REFERENCE TO RELATED APPLICATION

This application claims the priority of Chinese Patent Application No. 201810083952.2 filed on January 29, 2018, which is incorporated herein in its entirety by reference.

### TECHNICAL FIELD

The present disclosure relates to the field of solar cell technology, and in particular relates to a thin-film solar cell.

### BACKGROUND OF THE RELATED ART

With the rapid development of industry, energy and environmental problems have become more serious than ever, and the use of solar energy has become a research hotspot around the world. In the field of solar cell technology, copper indium gallium selenide (CIGS) is a direct band gap semiconductor. With the incorporation of Ga element, the band gap width of CIGS can be adjusted between 1.02 eV and 1.68 eV. CIGS exhibits a high absorption coefficient towards visible light and is the most promising material for producing high-efficiency low-cost thin-film solar cells.

The glass substrate of CIGS cell contains an alkaline element. An alkaline compound layer is vapor-deposited between the CIGS layer (absorption layer) and the Mo layer to adjust the alkaline element of the absorption layer. However, in the co-evaporation preparation of an absorption layer, if the processing temperature exceeds 500 degrees, the alkaline element diffuses from a high concentration region to a low concentration region of the absorption layer. After the preparation of the absorption layer is completed and before the absorption layer goes through the next processing, the temperature of the substrate decreases, thus the alkaline element diffuses back to the bottom of the CIGS layer, resulting in uncontrolled alkaline element on the surface of the CIGS layer, thereby making the alkaline element uncontrollable throughout the process. This reduces the photoelectric conversion efficiency of the CIGS cell.

### SUMMARY

The present disclosure has been accomplished to at least partially solve the technical problem in the prior art. The present disclosure provides a thin-film solar cell capable of enhancing controllability of alkaline element on the surface of the CIGS layer and improving the photoelectric conversion efficiency of the cells.

According to an aspect of the present disclosure, there is provided a thin-film solar cell, comprising:
a substrate;
a first conductive layer disposed on the substrate;
a first alkaline element layer disposed on the first conductive layer;
a light absorption layer disposed on the alkaline element layer;
a second alkaline element layer disposed on the light absorption layer; and
a transparent conductive layer disposed on the second alkaline element layer.

In the thin-film solar cell, a buffer layer may further be disposed between the second alkaline element layer and the transparent conductive layer.

In the thin-film solar cell, the first conductive layer may be a molybdenum layer.

In the thin-film solar cell, the molybdenum layer may have a thickness of about 200 to 500 nm and a square resistance of about 500 to 1000 mΩ.

In the thin-film solar cell, the light absorption layer may be a CIGS absorption layer, which may have a thickness of about 1.8 to 2.5 µm.

In the thin-film solar cell, the atomic ratio of the constituent elements of the CIGS absorption layer may satisfy: 0.75≤Cu/(In+Ga)≤ 1, 0.2≤Ga/(In+Ga)≤0.5.

In the thin-film solar cell, the buffer layer may be a cadmium sulfide layer, which may have a thickness of about 20 to 70 nm.

In the thin-film solar cell, the composition of the transparent conductive layer may be aluminum-doped zinc oxide.

In the thin-film solar cell, the transparent conductive layer may have a thickness of about 800 to 1200 nm and a square resistance of about 5 to 30 Ω.

In the thin-film solar cell, the first alkaline element layer may be one of NaF, KF, RbF, and CsF.

In the thin-film solar cell, the second alkaline element layer may be one of NaF, KF, RbF, and CsF.

According to the thin-film solar cell of the present disclosure, by providing the second alkaline element layer, an alkali metal element in the second alkaline element layer reacts with elements in the light absorption layer to form a film layer containing the alkali metal element, thereby changing the composition of the surface of the light absorption layer, and further changing the electronic structure of the light absorption layer by ion exchange, reducing the surface recombination of charge carriers between the layers, such that an open-circuit voltage of the cell is increased in the post-preparation processing, thereby improving the photoelectric conversion efficiency of the cell.

### BRIEF DESCRIPTION OF THE DRAWINGS

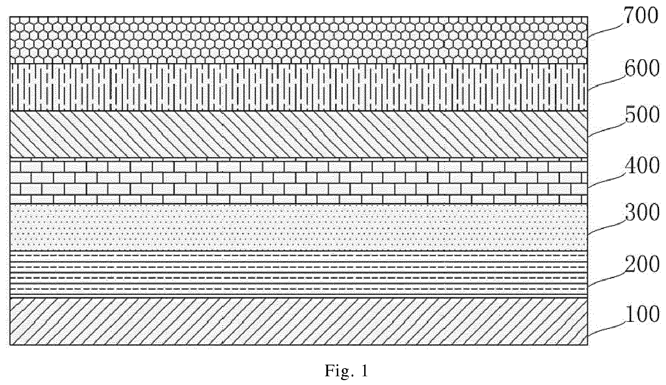

FIG. 1 is a structural schematic diagram of a thin-film solar cell according to an embodiment of the present disclosure.

### DETAILED DESCRIPTION

The embodiments of the present disclosure will be described in detail below with reference to the accompanying drawings. In the accompanying drawings, the same or similar reference numerals represent the same or similar elements or elements having the same or similar functions. The embodiments described hereinbelow with reference to the accompanying drawings are illustrative and are used to explain the present disclosure only, which may not be interpreted as limitations to the present disclosure.

As shown in FIG. 1, a thin-film solar cell according to the embodiment of the present disclosure includes a substrate 100 on which a first conductive layer 200, a first alkaline element layer 300, a light absorption layer 400, a second alkaline element layer 500, a buffer layer 600, and a transparent conductive layer 700 are sequentially disposed. In an exemplary embodiment, the substrate 100 may be a float glass, and the first conductive layer 200 may be a molybdenum layer. In an exemplary embodiment, the thin-film solar cell may be a flexible thin-film solar cell, and may also be a rigid thin-film solar cell. In the present embodiment, description is mainly made on a rigid thin-film solar cell.

By vapor-depositing the first alkaline element layer 300 between the light absorption layer 400 and the molybdenum layer (first conductive layer) 200, the content of alkaline element in the cell structure can be initially controlled, but in the co-evaporation preparation of the light absorption layer 400, if the processing temperature exceeds 500°C, the alkaline element diffuses from a high concentration region to a low concentration region of the light absorption layer 400. After the preparation of the light absorption layer 400 is completed and before the absorption layer goes through the next processing, the temperature of the substrate 100 decreases, and alkaline element diffuses back to the bottom of the light absorption layer 400, resulting it difficult to ensure control precision over the alkaline element on the surface of the light absorption layer 400. Therefore, in the present embodiment, a second alkaline element layer 500 is disposed between the light absorption layer 400 and the buffer layer 600, and by utilizing the characteristic of strong diffusibility of alkaline element, the alkaline element in the second alkaline element 500 can react with elements in the light absorption layer 400, so as to form a film layer containing alkaline element on the surface of the light absorption layer 400, thereby changing the composition of the surface of the light absorption layer 400, and further changing the electronic structure of the light absorption layer 400 by ion exchange, reducing the surface recombination of charge carriers between the layers, so that the open-circuit voltage of the cell is increased in the post-preparation processing, thereby improving the photoelectric conversion efficiency of the cell.

In an exemplary embodiment, in order to ensure the diffusion performance of the alkaline element in the first alkaline element layer 300 in the light absorption layer 400 while facilitating the reaction of the alkaline element with elements in the light absorption layer 400, the first alkaline element layer 300 may be one of NaF, KF, RbF, and CsF. In an exemplary embodiment, the second alkaline element layer 500 may also be one of NaF, KF, RbF, and CsF.

In an exemplary embodiment, the light absorption layer 400 may be a CIGS absorption layer, which may have a thickness of about 1.8 to 2.5 µm. After the second alkaline element layer 500 reacts with the CIGS absorption layer, a layer of XIGS film will be formed on the surface of the CIGS absorption layer, wherein X represents an alkali metal element in the second alkaline element layer 500, such as Na, K , Rb or Cs, etc.

In an exemplary embodiment, the atomic ratio of the constituent elements of the CIGS absorption layer satisfies: 0.75≤Cu/(In+Ga) ≤1, 0.2≤Ga/(In+Ga) ≤0.5. Under this ratio range, interface recombination can be effectively reduced, the band gap width can be adjusted and optimized, the open-circuit voltage can be increased, and the cell efficiency can be increased.

In an exemplary embodiment, in order to enhance the power generating performance of the thin-film solar cell, the molybdenum layer 200 may have a thickness of about 200 to 500 nm and a square resistance of about 500 to 1000 mΩ.

The buffer layer 600 can be disposed by making cadmium sulfide with chemical bath deposition. The cadmium sulfide layer may have a thickness of about 20 to 70 nm to ensure the interface reaction between the light absorption layer 400 and the transparent conductive layer 700 and increase the photoelectric conversion efficiency of the cell.

In an exemplary embodiment, in order to enhance the light transmittance, the composition of the transparent conductive layer 700 may be aluminum-doped zinc oxide (ZnO:Al). In an exemplary embodiment, the aluminum element may also be replaced with a Group 3 element. Meanwhile, in order to enhance the photoelectric conversion efficiency of the cell, the transparent conductive layer 700 may have a thickness of about 800 to 1200 nm and a square resistance of about 5 to 30 Ω.

According to the thin-film solar cell of the present disclosure, by disposing the second alkaline element layer, the alkali metal element in the second alkaline element layer reacts with elements in the light absorption layer to form a film layer containing the alkali metal element, thereby changing the composition of the surface of the light absorption layer, and further changing the electronic structure of the light absorption layer by ion exchange, reducing the surface recombination of charge carriers between the layers, such that the open-circuit voltage of the cell is increased in the post-preparation processing, thereby improving the photoelectric conversion efficiency of the cell.

The construction, features, and effects of the present disclosure have been described in detail with reference to the embodiments shown in the accompanying drawings. What described above are only preferred embodiments of the present disclosure. However, the scope of the present disclosure is not limited thereto, and any changes or replacements that can be easily conceived by those skilled in the art within the technical scope disclosed by the present disclosure shall fall within the scope of the present disclosure. Therefore, the scope of the present disclosure shall be defined by the following claims.

### LIST OF REFERENCE SIGNS:

100. Substrate
200. First conductive layer
300. First alkaline element layer
400. Light absorption layer
500. Second alkaline element layer
600. Buffer layer
700. Transparent conductive layer

## Claims

1. A thin-film solar cell, comprising:
a substrate (100);
a first conductive layer (200) disposed on the substrate (100);
a first alkaline element layer (300) disposed on the first conductive layer (200);
a light absorption layer (400) disposed on the first alkaline element layer (300);
a second alkaline element layer (500) disposed on the light absorption layer (400); and
a transparent conductive layer (700) disposed on the second alkaline element layer (500).

2. The thin-film solar cell according to claim 1, wherein a buffer layer (600) is further disposed between the second alkaline element layer (500) and the transparent conductive layer (700).

3. The thin-film solar cell according to claim 1, wherein the first conductive layer (200) is a molybdenum layer.

4. The thin-film solar cell according to claim 3, wherein the molybdenum layer has a thickness of 200 to 500 nm and a square resistance of 500 to 1000 mΩ.

5. The thin-film solar cell according to claim 1, wherein the light absorption layer (400) is a copper indium gallium selenide (CIGS) absorption layer having a thickness of 1.8 to 2.5 µm.

6. The thin-film solar cell according to claim 5, wherein an atomic ratio of constituent elements of the CIGS absorption layer satisfies: 0.75 ≤ Cu/(In+Ga) ≤ 1, 0.2 ≤Ga/(In+Ga) ≤ 0.5.

7. The thin-film solar cell according to claim 2, wherein the buffer layer (600) is a cadmium sulfide layer having a thickness of 20 to 70 nm.

8. The thin-film solar cell according to claim 1, wherein a composition of the transparent conductive layer (700) is aluminum-doped zinc oxide.

9. The thin-film solar cell according to claim 1, wherein the transparent conductive layer (700) has a thickness of 800 to 1200 nm and a square resistance of 5 to 30 Ω.

10. The thin-film solar cell according to any one of claims 1 to 8, wherein the first alkaline element layer (300) is one of NaF, KF, RbF, and CsF.

11. The thin-film solar cell according to any one of claims 1 to 8, wherein the second alkaline element layer (500) is one of NaF, KF, RbF, and CsF.

12. The thin-film solar cell according to any one of claims 1 to 8, wherein the substrate (100) is a float glass.

13. The thin-film solar cell according to any one of claims 1 to 8, wherein the thin-film solar cell is flexible.

14. The thin-film solar cell according to any one of claims 1 to 8, wherein the thin-film solar cell is rigid.
